# EUROPEAN PATENT SPECIFICATION

(11) **EP 3 808 592 B1**
(45) Date of publication and mention of the grant of the patent: **24.01.2024**
(21) Application number: 19203900.6
(22) Date of filing: 17.10.2019
(51) Int. Cl.: B60L 58/12, B60L 58/16

(54) **METHOD FOR DETERMINING THE SUPPORT OF ENERGY CONTENT AND POWER OF A BATTERY**
VERFAHREN ZUR BESTIMMUNG DER UNTERSTÜTZUNG DES ENERGIEGEHALTS UND DER LEISTUNG EINER BATTERIE
PROCÉDÉ DE DÉTERMINATION DU SUPPORT DE CONTENU EN ÉNERGIE ET D'ALIMENTATION D'UNE BATTERIE

(43) Date of publication of application: 21.04.2021
(73) Proprietor: Samsung SDI Co., Ltd., Gyeonggi-do 17084 (KR)
(72) Inventor: Janek, Dr. Alex, 8041 Graz-Liebenau (AT); Doczy, Dr. Stefan, 8054 Pirka (AT)
(74) Representative: Gulde & Partner

(56) References cited:
- EP-A1- 3 534 168
- EP-A2- 1 619 512
- WO-A1-2018/081818
- US-A1- 2008 224 709
- US-A1- 2013 090 872
- US-A1- 2014 015 537
- US-A1- 2014 111 164
- US-A1- 2017 106 760
- US-A1- 2019 064 281

## Description

### Field of the Invention

The present invention relates to a method for determining the support of energy content and power of a battery. The invention further relates to a detection system for determining the support of energy content and power of a battery. Furthermore, the invention relates to an electric vehicle comprising such a detection system.

### Technological Background

In recent years, vehicles have been developed using electric power as a source of motion. An electric vehicle is an automobile that is powered by an electric motor using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while highcapacity rechargeable batteries are used as the power supply for hybrid vehicles and the like.

Rechargeable batteries may be used as a battery module formed of a plurality of unit battery cells coupled in series and/or in parallel so as to provide a high energy density, in particular for motor driving of a hybrid vehicle. A battery module may be formed by interconnecting the electrode terminals of the plurality of unit battery cells depending on a required amount of power and in order to realize a high-power rechargeable battery. The cells can be connected in series, parallel or in a mixture of both to deliver the desired voltage, capacity, or power density. Components of battery packs include the individual battery modules and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery control unit, often referred to as battery management unit (BMU) and/or battery management system (BMS), for processing the aforementioned information. The battery control unit may comprise controllers of the various electrical consumers and contain suitable internal communication busses, e.g. a SPI or CAN interface. The battery control unit may further communicate with each of the battery submodules, particularly with a cell supervision circuit (CSC) of each battery submodule. The CSC may be further connected to a cell connection and sensing unit (CCU) of a battery submodule that interconnects the battery cells of the battery submodule. Thus, the battery control unit may be provided for managing the battery pack, such as by protecting the battery from operating outside its safe operating area, monitoring its state, calculating secondary data, reporting that data, controlling its environment, authenticating it and/or balancing it. Typically, the battery control unit may control a relay to a load and may switch the load in various fault situations.

Safety relevant cell modeling is required due to numerous driving assistance systems for electric vehicles, e.g. battery electric vehicles or plugin hybrid electric vehicles (PHEV). Integration of the driving systems into vehicles supports the vehicle driver and increases driving safety but transfers more and more responsibilities of driving from the driver to the automated assistance systems. It is essential for the function of such automated assistance systems to guarantee a defined energy level together with a certain power level for a defined time frame. State of the art cell modeling calculations do thereby not meet safety standards as for example ASIL B (automotive safety integrity level B) requirements.

Generating results in safety standards according to ASIL B quality has high demands on plausibility and redundancy of all inputs required. This concerns measurement inputs but even also models and modelling data which deliver parts forming the overall result.

As cell models are very complex models approximating cell response based on measured, fitted and interpolated data, it is very difficult or even impossible to use them to generate ASIL B quality results.

The US 2014/0015537A1 discloses a control system for a battery assembly of a plurality of batteries which determines whether the battery assembly can be reused based on an open voltage and an internal resistance and thresholds thereof. The US 2013/0090872 A1 discloses a method for reusing a battery based on the number of exceeding events of an upper-limit voltage and the internal resistance. The US 2019/0064281 A1 discloses a sensor module which decreases a measurement interval in the critical decay regime based on voltage and resistor thresholds. The US 2008/0224709 A1 discloses a method for determining an internal resistance based on an average value of an estimation current. The WO 2018/081818 A1 uses a battery model to perform power estimation. The EP 1 619 512 A2 discloses a particular method for determination of the internal resistance of a battery. The US 2014/0111164 A1 discloses a control apparatus using an internal resistance table as input for deriving charging currents. The US 2017/0106760A1 discloses a method of estimating battery capacity. The EP 3 534 168 A1 discloses a method of determining a state of charge.

It is therefore an object of the present invention to overcome or mitigate at least some of the drawbacks of the prior art. In particular, it is an object to provide a method and a detection system for determining the support of an energy content and a power of a battery providing with high reliability which is operable to meet ASIL B requirements.

### Summary of Invention

Embodiments of the present disclosure seek to solve at least one of the problems existing in the prior art to at least some extent.

A method for determining the support of an energy content and a power of a battery for an electric vehicle is disclosed according to claim 1.

Expressed in other words, determining the support means availability, or in particular sufficient availability, of an energy content and a power of a battery. Sufficient energy of the battery is indicated in the present invention by the battery voltage if it is higher than a threshold voltage. Sufficient power is indicated in the present invention by the internal resistance of the battery if it is below a threshold resistance. Full support is only guaranteed, when both voltage and internal resistance fulfill the conditions. The battery voltage may preferably be a system voltage of a stack of battery cells forming the battery, but the invention is not restricted thereto. The battery voltage to be measured may preferably be the open-loop voltage. Internal resistance and battery voltage, i.e. the open-loop voltage, both depend on time, the internal resistance increasing under discharge and the voltage decreasing under discharge and are therefore valuable indicative quantities characterizing the state of the battery.

The method has the advantage that beyond the measuring and determination of the relevant quantities, simple mathematical operations are used to determine or verify if the support is fulfilled, respectively. In particular, comparators and a simple logical operator can be used for verification. Input quantities are the determined internal resistance and the measured voltage of the battery. Since these quantities can be measured or determined with ASIL B quality, the determination if power and energy is supported may then in consequence as well be verified in ASIL B quality. The comparisons with each threshold value and the consecutive logical check provide simple mathematical operations. Cumbersome cell models are circumvented by the present invention. Measurement or determination errors of the inputs can be simply accumulated to obtain a resulting error, which cannot be reached by cell models as known in the state of the art.

The method may comprise determining that the energy content and the power of a battery of an electric vehicle is not supported, if the measured voltage is less than the predetermined threshold voltage and/or the determined resistance is larger than the predetermined threshold resistance. Also here, a simple logical operator is required to identify the lack of support. The logical operator may be an AND-logical unit and may obtain signals indicative of the support from comparator units and outputting a signal, e.g. digital signal, indicative that both the energy and the power are supported or not supported, else.

The method comprises determining the voltage during a pause time interval in which the voltage of the battery is not controlled to be held at a constant voltage. The voltage of the battery is controlled by a control unit of the electric vehicle to yield a constant and fixed output voltage. For example such a voltage may be 48V, but the invention is not restricted thereto. A control loop may be frequently used to keep the voltage level constant despite a decay of the actual open loop voltage of the battery. Therefore, in the pause time interval, the battery voltage undergoes relaxation to the actual voltage of the battery and measurement of the actual voltage of the battery becomes feasible. The pause time interval may be periodically provided with a frequency of for example 10 minutes, but the invention is not restricted thereto. This frequency may be imposed by a control unit of an electrical vehicle.

Determining the support of the energy content comprises determining the voltage within a pause time interval, in which a battery current is controlled to be held below a zero level threshold current. A zero level threshold voltage may be for example 100 mA or less, but the invention is not restricted thereto. When the battery current is reduced into such a small magnitude regime, the battery is less loaded, which significantly improves precision of the measurement of the battery voltage. The control of the battery current can be operated by a current control unit of the electric vehicle. In preferred embodiments, the battery current is held below the zero level threshold current throughout the whole pause time interval.

The support of the energy content comprises measuring the voltage at a measuring time being within the pause time interval, wherein the measuring time is equal to or longer than the relaxation time of the battery with respect to the start of the pause time interval. Relaxation time refers to the time scale on which the voltage battery has sufficiently decayed toward its actual voltage, or open-loop voltage. For example, the relaxation time may be 90 seconds and/or measuring time may be at 90 seconds, but the invention is note restricted thereto. The relaxation time may be less than 90 seconds, e.g. 60 seconds or 40 seconds. The relaxation time may also be larger than 90 seconds, e.g. 120 seconds or 150 seconds or even 180 seconds or more, but the invention is not restricted thereto. Thus, when measuring takes place at the relaxation time or beyond the relaxation time, the precision of the measurement of the battery voltage is further improved.

In an illustrative example not forming part of the invention determining the support of the power may comprise measuring a temperature of the battery and comparing the internal resistance with a predetermined temperature-dependent threshold resistance corresponding to the measured temperature. The inclusion of temperature-dependent threshold resistances takes beneficially into account that the internal resistance is dependent on temperature. Such an inclusion of temperature dependence allows the method to be applicable for various temperatures.

In an illustrative example not forming part of the invention determining the support of the power may comprise selecting the predetermined threshold resistance corresponding to the measured temperature from a look-up table, the look-up table including predetermined threshold resistances in dependence of the temperature. A look-up table may have stored various previously determined threshold resistance values as function of temperature.

In an illustrative example not forming part of the invention the method may comprise determining if the temperature is higher than a minimum threshold temperature. For too low temperatures, e.g. around 3, 4 or 5 °C but the invention is not restricted thereto, the relaxation time may become very long and a measurement of the battery voltages may lack precision. Therefore, by determining that the actual temperature is higher than a minimum threshold temperature guarantees that the determined resistance or the measured voltage meets sufficient precision.

In an illustrative example not forming part of the invention determining the support of the power may comprise applying a test current to the battery for a predefined test time, and determining a voltage drop, wherein the voltage drop is the difference between the measured voltage at the start of the test time and the measured voltage at the end of the test time, further comprising calculating the internal resistance R_{sys} via dividing the determined voltage drop through the applied test current: R_{sys} = ΔU_{sys} / Iₜₑₛₜ. The test current may be a discharging current such that the battery voltage becomes less than at the beginning of the test time. But the invention is not restricted thereto and the test current may also be a charging current such that the battery voltage becomes higher than at the beginning of the test time. The test time may be as well equal or larger than a relaxation time, e.g. as described above, but the invention is not restricted thereto and the test time window may differ from the relaxation time as described above. In temporal order, the determining the support of the power may be performed after the determining of the energy level within the same pause time interval. The voltage measured at the beginning of the test time may be identical to the voltage at or after relaxation time as described above.

In another aspect of the invention, an electrical vehicle including a detection system for determining the support of an energy content and a power of a battery for an electric vehicle is disclosed is provided according to the claim 5.

The detection system shares the advantages as described above in the context of the described method. For the sake of clarity, some of the advantages are repeated to emphasize the benefit of the detection system according to the invention with respect to the state of the art. Beyond the measuring and determination of the quantities, simple mathematical operations, e.g. operated by comparators and logical operators, are used to determine or verify the support, respectively. Basic inputs are the determined internal resistance and the measured voltage of the battery. Since the batter voltage can be measured with ASIL B quality, the determination if power and energy is supported can in consequence as well be verified in ASIL B quality. The comparisons with each threshold value and the consecutive logical check provide simple mathematical operations. Cumbersome cell models are circumvented by the present invention. Measurement or determination errors of the inputs can be simply accumulated to obtain a resulting error.

Further advantages of the below listed preferred embodiments for the detection system can be taken from the section above regarding the corresponding method steps of the disclosed method.

In a preferred embodiment, the logical unit may be configured to determine that the energy content and the power of a battery of an electric vehicle is not supported, if the measured voltage is less than the predetermined threshold voltage and/or the determined resistance is larger than the predetermined threshold resistance. The logical unit may be realized by an AND-logical unit.

The detection system comprises a voltage measuring unit configured to measure the voltage during a pause time interval in which the voltage of the battery is not controlled to be held at a constant voltage.

The voltage measuring unit is configured to measure the voltage at a measuring time being within the pause time interval, wherein the measuring time is equal to or longer than the relaxation time of the battery with respect to the start of the pause time interval.

The voltage measuring unit is configured to measure the voltage within a pause time interval, in which a battery current is controlled to be held below a zero level threshold current.

The detection unit may comprise a temperature measuring unit configured to measure a temperature of the battery, wherein the second comparator unit is configured to comparing the internal resistance with a predetermined temperature-dependent threshold resistance corresponding to the measured temperature.

The detection system may comprise a selecting unit configured to select the predetermined threshold resistance corresponding to the measured Temperature from a look-up table, the look-up table including predetermined threshold resistances Rₗᵢₘ in dependence of the temperature.

The detection system may comprise a temperature comparing unit configured to compare the measured temperature with a minimum threshold temperature and to determine, if the measured temperature is higher than the minimum threshold temperature.

The detection system may comprise a current control unit configured to apply a test current to the battery for a predefined test time, and the voltage measurement unit may be configured to determine a voltage drop, wherein the voltage drop is the difference between the measured voltage at the start of the test time and the measured voltage at the end of the test time, and further comprising division unit calculating the internal resistance via dividing the determined voltage drop through the applied test current: R_{sys} = ΔU_{sys} / Iₜₑₛₜ.

Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a method and a detection system for determining the support of an energy content and a power of a battery for an electric vehicle according to an embodiment of the invention and to an illustrative example not forming part of invention; and
Fig. 2 illustrates a method of determining the support of the energy content according to an embodiment of the invention; and
Fig. 3 illustrates a method of determining the support of the power for illustrative purposes and not covered by the claims.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The electronic or electric devices, e.g. the detection system, and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices, e.g. of the detection system, may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

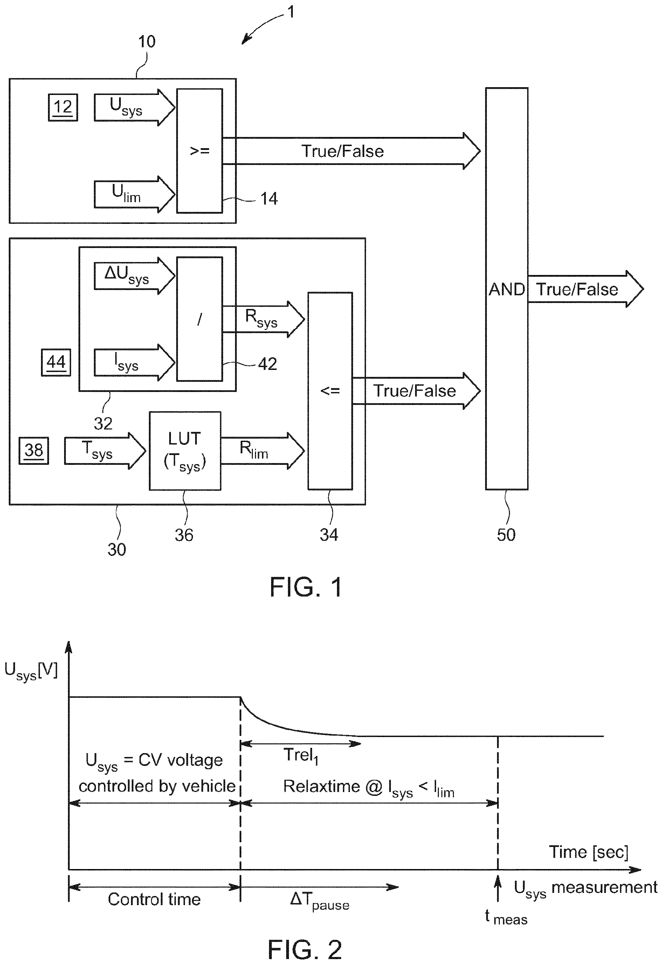

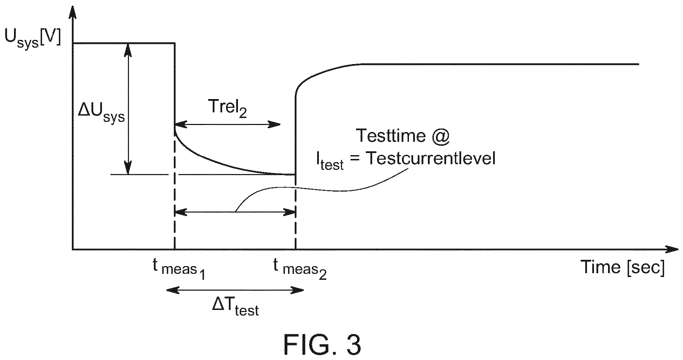

Fig. 1 shows a method and a detection system 1 for determining the support of an energy content and a power of a battery for an electric vehicle according to an embodiment of the invention. Reference will be made in the following to Figs. 2 and 3, which provide detailed illustrations of the method, in particular, Fig. 2 shows the method of determining the support of the energy content according to a preferred embodiment of the invention and Fig. 3 shows the method of determining the support of the power according to an illustrative example not forming part of the invention.

The method for determining the support of an energy content and a power of a battery for an electric vehicle will be described in the following together with the detection system 1 as exemplarily shown in Fig. 1.

The method for determining the support of an energy content and a power of a battery for an electric vehicle comprises the determining of the support of the energy content. The detection system 1 therefore comprises a first determination unit 10 which is configured to determine the support of the energy content.

The method comprises measuring a voltage U_{sys} of the battery. The voltage U_{sys} may refer to the stack voltage of a battery comprising a stack of battery cells. The detection system 1 therefore comprises a voltage measuring unit 12. The method further comprises comparing the measured battery voltage U_{sys} with a predetermined threshold voltage Uₗᵢₘ and determining if the measured voltage U_{sys} is equal or larger than the predetermined threshold voltage Uₗᵢₘ. Therefore, the first determination unit 10 comprises a first comparator unit 14. The first comparator unit 14 may receive for example an analog input signal from the voltage measuring unit 12 indicative of the measured voltage U_{sys}, may then for example compare the received value with a predetermined threshold voltage Uₗᵢₘ and may output for example a digital signal indicative of if the measured voltage U_{sys} is equal or larger than the predetermined threshold voltage Uₗᵢₘ.

The method for determining the support of an energy content and a power of a battery for an electric vehicle further comprises the determining of the support of the power. The detection system 1 therefore comprises a second determination unit 30.

The method comprises determining an internal resistance R_{sys} of the battery. The second determination unit 30 may therefore comprise a resistance determination unit 32 which is configured to determine the internal resistance R_{sys}.

Then, the method comprises comparing the determined internal resistance R_{sys} with a predetermined threshold resistance Rₗᵢₘ and determines if the determined internal resistance R_{sys} is equal or less than the predetermined threshold resistance Rₗᵢₘ. Therefore, the second determination unit 30 comprises a second comparator unit 34. The second comparator unit 34 may receive for example an analog input signal from the resistance determination unit 32 indicative of the determined internal resistance R_{sys}, may then compare the received value with the predetermined threshold resistance Rₗᵢₘ and may output for example a digital signal indicative of if the determined internal resistance R_{sys} is equal or less than the predetermined threshold resistance Rₗᵢₘ.

In a further step, the method comprises determining that the energy content and the power of a battery of an electric vehicle is supported, if both the measured voltage U_{sys} is equal or larger than the predetermined threshold voltage Uₗᵢₘ and the determined resistance R_{sys} is equal or less than the predetermined threshold resistance Rₗᵢₘ. The detection system 1 therefore may comprise a logical unit 50 configured to output a digital signal indicative of that both conditions as described above are fulfilled.

The method and detection system 1 has the advantage that beyond the measuring and determination of the quantities, simple mathematical operations are used to determine the support, respectively. Input quantities can be measured with ASIL B quality, and, in consequence, as well be verified in ASIL B requirements, since the comparisons with each threshold value and the consecutive logical check provide simple mathematical operations which allow furthermore straightforward estimation of error, which cannot be achieved with cell models.

In a further step the method may comprise determining that the energy content and the power of a battery of an electric vehicle is not supported, if the measured voltage U_{sys} is less than the predetermined threshold voltage Uₗᵢₘ and/or the determined resistance R_{sys} is larger than the predetermined threshold resistance Rₗᵢₘ. Therefore, the logical unit 50 of the detection system 1 may be an AND-logical unit. In general, the input signals received by the logical unit 50 may not be synchronically received but in sequential temporal order as described below. Therefore, the logical unit 50 may have an internal storage to store a received input signal until the other input signal is received. Then, after this time delay, the logical unit 50 may be configured to determine if energy content and the power of a battery of an electric vehicle are supported or not as described above.

Regarding the method of determining the support of the energy content in detail, the method comprises measuring the battery voltage U_{sys} during a pause time interval ΔTₚₐᵤₛₑ in which the battery voltage U_{sys} of the battery is not controlled to be held at a constant voltage, see for example Fig. 2 of the present invention.

Usually, the battery voltage U_{sys} may be controlled by a control loop, e.g. of the electric vehicle, to be held at a particular level to yield a constant output of a fixed voltage. Nevertheless, the actual battery voltage or the actual open loop voltage of the battery might decay. For example, a battery voltage may be 48V and the open loop voltage might decay to 42V or 43V, but the invention is not restricted thereto. Therefore, in the pause time interval ΔTₚₐᵤₛₑ, as can be seen for example in Fig. 2, the battery voltage U_{sys} undergoes relaxation to the actual voltage of the battery and measurement. Thus, actual voltage of the battery can be measured. The pause time interval ΔTₚₐᵤₛₑ may be periodically provided with a frequency of for example 10 minutes, but the invention is not restricted thereto. This frequency may be imposed by a control unit of the electrical vehicle. In Fig. 2, the constant voltage regime refers to the initial part referred to as control time on the time axis. During a pause time interval ΔTₚₐᵤₛₑ, the voltage U_{sys} then undergoes relaxation toward an open loop voltage. As can be seen in Fig. 2, the measuring point tₘₑₐₛ is within the pause time interval ΔTₚₐᵤₛₑ, where the battery voltage has relaxated and/or even saturated.

Further, as it is also shown in Fig. 2, the method includes to measure the battery voltage U_{sys} within the pause time interval ΔTₚₐᵤₛₑ, in which a battery current I_{sys} is controlled to be held below a zero level threshold current Iₗᵢₘ. Then the battery load is reduced and the precision of the measurement of the voltage U_{sys} improved. The current control is operated by a current control unit 44 of the electric vehicle. A zero level threshold voltage may be for example 100 mA or less, but the invention is not restricted thereto. As can be seen in Fig. 2, in a preferred embodiment, the battery current I_{sys} is held below the zero level threshold current Iₗᵢₘ throughout the whole pause time interval ΔTₚₐᵤₛₑ to improve the precision of measurement.

As can be seen as well in Fig. 2, the determining of the support of the energy content comprises measuring the battery voltage U_{sys} at a measuring time tₘₑₐₛ being within the pause time interval ΔTₚₐᵤₛₑ, wherein the measuring time tₘₑₐₛ is equal to or longer than the relaxation time Tᵣₑₗ₁ of the battery with respect to the start of the pause time interval ΔTₚₐᵤₛₑ. Then, the battery voltage U_{sys} has sufficiently saturated and the precision of the measurement is improved. In the example embodiment of Fig. 2, the measuring time tₘₑₐₛ is longer than the relaxation time Tᵣₑₗ₁, but the invention is not restricted thereto and in other embodiments the measuring time tₘₑₐₛ and the relaxation time Tᵣₑₗ₁ may coincide with each other. For example, the relaxation time may be 90 seconds or but the invention is note restricted thereto. The relaxation time may be 130 seconds or 170 seconds or even 200 seconds or more. The voltage measuring unit 12 may be configured to measure the battery voltage according to the above described embodiments.

Regarding the method of determining the support of the energy content in detail, the method may, in an illustrative example not forming part of the invention as shown in Fig. 1, comprise measuring a temperature T_{sys} of the battery or its close environment and compare the internal resistance R_{sys} with a predetermined temperature-dependent threshold resistance Rₗᵢₘ that refers to the measured temperature T_{sys}. The detection system 1 may therefore comprise a temperature measuring unit 38. The threshold resistance Rₗᵢₘ may thus be temperature-dependent and therefore method and detection system can operate in various temperature conditions. The second comparator unit 34 may then be configured to receive the threshold resistance Rₗᵢₘ that corresponds to the measured temperature.

In an illustrative example not forming part of the invention as can be seen in Fig. 1, determining the support of the power may comprise selecting the predetermined threshold resistance Rₗᵢₘ corresponding to the measured temperature T_{sys} from a look-up table 36. The look-up table 36 may thereby include predetermined threshold resistances Rₗᵢₘ in dependence of stored temperature values.

In a further illustrative example not forming part of the invention the method may comprise determining if the measured temperature T_{sys} is higher than a minimum threshold temperature, which is not explicitly shown in Fig. 1. The detection system 1 may therefore comprise beside a temperature measuring unit 38 a temperature comparator unit, here not shown, which is configured to determine, if the temperature T_{sys} is higher than a minimum threshold temperature. Only if this condition is fulfilled, the method and the detection system as described above and below, may be operated. Namely, for too low temperatures, e.g. around 3, 4 or 5 °C but the invention is not restricted thereto, the relaxation time may become very long and measurements may thus lack precision. Therefore, by determining that the actual temperature is higher than a threshold guarantees that the determined resistance or the measured voltage has sufficient precision.

In a further illustrative example not forming part of the invention the method of determining the support of the power comprises may comprise applying a test current Iₜₑₛₜ to the battery for a predefined test time ΔTₜₑₛₜ, as can be seen in Fig. 3 of the present example.

Therefore, a current control unit 44 may be included, see schematically in Fig. 1, preferably of the electric vehicle. Here, in Fig. 3, merely as an example, the test current Iₜₑₛₜ refers to a discharging current which leads to a negative voltage drop as function of time, but the example is not restricted thereto and the example may also be performed with a charging current Iₜₑₛₜ, see also description below.

The method further may comprise measuring a voltage drop ΔU_{sys} by the voltage measuring unit 12, wherein the voltage drop ΔU_{sys} is the difference between the measured voltage at the start, first measuring time tₘₑₐₛ₁, of the test time ΔTₜₑₛₜ and the measured voltage at the end, second measuring time tₘₑₐₛ₂, of the test time ΔTₜₑₛₜ. Both, the voltage drop ΔU_{sys} and the test current Iₜₑₛₜ are consecutively supplied as inputs to a divisor unit 42 of the resistance determination unit 32, see Fig. 1.

The method may then further comprise calculating the internal resistance R_{sys} via dividing the measured voltage drop ΔU_{sys} through the applied test current Iₜₑₛₜ, which leads to the internal resistance R_{sys} = ΔU_{sys} / Iₜₑₛₜ. The divisor unit 42 which is configured to perform the above division may then supply a signal indicative of the determined internal resistance R_{sys} as input to the second comparator unit 34 as described above. The divisor unit 42 may also account for the signum by taking the modulus ΔU_{sys} = |U_{sys} (tₘₑₐₛ₁) - U_{sys} (tₘₑₐₛ₂)| to calculate a positive defined resistance, when discharging or charging test current Iₜₑₛₜ is used. The test time ΔTₜₑₛₜ may be as well equal or larger than a relaxation time Tᵣₑₗ₂, e.g. as described above, but the invention is not restricted thereto and the test time ΔTₜₑₛₜ may be different than the relaxation time, in particular, higher. In temporal order, determining the support of the power may be performed after the determining of the energy level, the latter shown in Fig. 2, within the same pause time interval ΔTₚₐᵤₛₑ. The voltage measured at the start tₘₑₐₛ₁ of the test time may in consequence be the same as the voltage U_{sys} at or after relaxation time Tᵣₑₗ₁ or at measuring time tmeas as viewed in Fig. 2.

In summary, the disclosed method and the detection system 1 have the advantage that simple mathematical operations are used to determine or verify if a support of energy and power is fulfilled, respectively. In particular, comparators and simple logical operators can be used for verification. All required input quantities, e.g. temperature, voltage or cell voltage, current, time, pre measurement of the threshold resistances, can be done according to ASIL B standards, such that in consequence the verification of the support of energy and power may as well be generated meeting ASIL B quality with the underlying principle.

The positioning of the measuring elements temperature measuring unit 38, current control unit 44, voltage measuring unit 12 and temperature comparison unit corresponding to the first and second determination unit 10, 30, respectively, as shown in Fig. 1 is only an example but the invention is not restricted thereto. The positioning can be reversed and interchanged and the measuring units may even be external. The positioning in Fig. 1 is only schematically as the person skilled in the art would readily identify.

In a further aspect of the invention, not explicitly shown, an electrical vehicle is disclosed, which comprises a detection system 1 as described in the various embodiments above.

### Reference signs

- 1: detection system

- 10: first determination unit
- 12: voltage measuring unit
- 14: first comparator unit

- 30: second determination unit
- 32: resistance determination unit
- 34: second comparator unit
- 36: look-up table
- 38: temperature measuring unit
- 42: divisor unit
- 44: current control unit

- 50: logical unit

- U_{sys}: battery voltage
- Uₗᵢₘ: threshold voltage
- ΔU_{sys}: voltage drop

- I_{sys}: battery current
- Iₗᵢₘ: zero level threshold current
- Iₜₑₛₜ: test current

- T_{sys}: temperature

- ΔTₚₐᵤₛₑ: pause time interval
- tₘₑₐₛ: measuring time
- Tᵣₑₗ₁: relaxation time

- R_{sys}: internal resistance
- Rₗᵢₘ: threshold resistance
- ΔTₜₑₛₜ: test time
- tₘₑₐₛ₁: first measuring time
- tₘₑₐₛ₂: second measuring time
- Tᵣₑₗ₂: relaxation time

## Claims

1. A method for determining the sufficient availability of energy content and power of a battery of an electric vehicle:
wherein determining the sufficient availability of energy content comprises:
- measuring the voltage (U_{sys}) of the battery;
- comparing the measured voltage (U_{sys}) with a predetermined threshold voltage (Uₗᵢₘ) and determining if the measured voltage (U_{sys}) is equal or larger than the predetermined threshold voltage (Uₗᵢₘ);
wherein determining the sufficient availability of power comprises:
- determining the internal resistance (R_{sys}) of the battery;
- comparing the determined internal resistance (R_{sys}) with a predetermined threshold resistance (Rₗᵢₘ) and determining if the determined internal resistance (R_{sys}) is equal or less than the predetermined threshold resistance (Rₗᵢₘ); determining that the energy content and the power of the battery of the electric vehicle are sufficient, if both the measured voltage (U_{sys}) is equal or larger than the predetermined threshold voltage and the determined resistance (R_{sys}) is equal or less than the predetermined threshold resistance (Rₗᵢₘ);
**characterized in that**,
determining the sufficient availability of the energy content further comprises:
- control the voltage (U_{sys}), through a control unit of the vehicle, to be at a constant level (CV) during a control time period;
- pause control of the voltage during a pause time interval (ΔTₚₐᵤₛₑ) following the control time period while controlling the battery current (I_{sys}), through a current control unit of the vehicle, during the pause time interval (ΔTₚₐᵤₛₑ) to be below a zero level threshold current (Iₗᵢₘ); and
- measure the voltage (U_{sys}) during the pause time interval by measuring the voltage (U_{sys}) at a measuring time (tₘₑₐₛ) being within the pause time interval (ΔTₚₐᵤₛₑ), wherein the measuring time (tₘₑₐₛ) is equal to or longer than a relaxation time (Tᵣₑₗ) of the voltage (U_{sys}) with respect to the start of the pause time interval (ΔTₚₐᵤₛₑ).

2. The method of claim 1, wherein the method comprises determining that the energy content and the power of the battery of the electric vehicle is not available, if the measured voltage (U_{sys}) is less than the predetermined threshold voltage (Uₗᵢₘ) and/or the determined resistance (R_{sys}) is larger than the predetermined threshold resistance (Rₗᵢₘ).

3. The method of one of the claims 1 to 2, wherein the zero level threshold current (Iₗᵢₘ) is 100 mA or less.

4. The method of claims 1 to 3, wherein determining the availability of the energy content is only performed if it is determined that the temperature (T_{sys}) is higher than a minimum threshold temperature.

5. Electrical vehicle including a detection system (1) for determining the sufficient availability of energy content and power of a battery of the electric vehicle, comprising:
a first determination unit (10) to determine the sufficient availability of energy content,
comprising:
- a measuring unit (12) configured to measure the voltage (U_{sys}) of the battery;
- a first comparator unit (14) configured to compare the measured voltage (U_{sys}) with a predetermined threshold voltage (Uₗᵢₘ) and determining if the measured voltage (U_{sys}) is equal or larger than the predetermined threshold voltage (Uₗᵢₘ);
a second determination unit (30) to determine the sufficient availability of power, comprising:
- a resistance determination unit (32) configured to determine the internal resistance (R_{sys}) of the battery;
- a second comparator unit (34) configured to compare the determined internal resistance (R_{sys}) with a predetermined threshold resistance (Rₗᵢₘ) and determining if the internal resistance (R_{sys}) is equal or less than the predetermined threshold resistance (Rₗᵢₘ);
a logical unit (50) configured to determine if the energy content and the power of the battery of an electric vehicle are sufficient, if both the measured (U_{sys}) is equal or larger than the predetermined threshold voltage (Uₗᵢₘ) and the resistance (R_{sys}) is equal or less than the predetermined threshold resistance (Rₗᵢₘ),
a control unit configured to control the voltage (U_{sys}) at a constant level and subsequently pause control of the voltage during a pause time interval (ΔTₚₐᵤₛₑ) while the battery current (I_{sys}) is controlled through a current control unit of the vehicle during the pause time interval (ΔTₚₐᵤₛₑ) to be below a zero level threshold current (Iₗᵢₘ), and
wherein the first determination unit (10) is configured to measure the voltage (U_{sys}) during the pause time interval by measuring the voltage (U_{sys}) at a measuring time (tₘₑₐₛ) being within the pause time interval (ΔTₚₐᵤₛₑ), wherein the measuring time (tₘₑₐₛ) is equal to or longer than a relaxation time (Tᵣₑₗ) of the voltage (U_{sys}) with respect to the start of the pause time interval (ΔTₚₐᵤₛₑ).

6. Electrical vehicle (1) of claim 5, wherein the logical unit (50) is configured to determine that the energy content and the power of a battery of an electric vehicle is not available, if the measured voltage (U_{sys}) is less than the predetermined threshold voltage (Uₗᵢₘ) and/or the determined resistance (R_{sys}) is larger than the predetermined threshold resistance (Rₗᵢₘ).

7. The electrical vehicle of claim 6, wherein the zero level threshold current (Iₗᵢₘ) is 100 mA or less.

## Patentansprüche

1. Verfahren zur Bestimmung der ausreichenden Verfügbarkeit von Energiegehalt und Leistung einer Batterie eines Elektrofahrzeugs:
wobei das Bestimmen der ausreichenden Verfügbarkeit des Energiegehalts umfasst:
- Messung der Spannung (U_{sys}) der Batterie;
- Vergleichen der gemessenen Spannung (U_{sys}) mit einer vorbestimmten Schwellenspannung (Uₗᵢₘ) und Bestimmen, ob die gemessene Spannung (U_{sys}) gleich oder größer als die vorbestimmte Schwellenspannung (Uₗᵢₘ) ist;
wobei das Bestimmen der ausreichenden Verfügbarkeit von Leistung umfasst:
- Bestimmen des Innenwiderstands (R_{sys}) der Batterie;
- Vergleichen des bestimmten Innenwiderstands (R_{sys}) mit einem vorbestimmten Schwellenwiderstand (R ₗᵢₘ) und Bestimmen, ob der bestimmte Innenwiderstand (R_{sys}) gleich oder kleiner als der vorbestimmte Schwellenwiderstand (Rₗᵢₘ) ist;
Bestimmen, dass der Energiegehalt und die Leistung der Batterie des Elektrofahrzeugs ausreichend sind, wenn sowohl die gemessene Spannung (U_{sys}) gleich oder größer als die vorbestimmte Schwellenspannung ist als auch der ermittelte Widerstand (R_{sys}) gleich oder kleiner als der vorbestimmte Schwellenwiderstand (Rₗᵢₘ) ist;
**dadurch gekennzeichnet, dass**
das Bestimmen der ausreichenden Verfügbarkeit des Energiegehalts ferner umfasst:
- Steuern der Spannung (U_{sys}) über eine Steuereinheit des Fahrzeugs so, dass sie während eines Steuerzeitraums auf einem konstanten Niveau (CV) liegt;
- Pausenregeln der Spannung während eines Pausenzeitintervalls (ΔTₚₐᵤₛₑ), das auf den Steuerzeitraum folgt, während der Batteriestrom (I_{sys}) während des Pausenzeitintervalls (ΔTₚₐᵤₛₑ) durch eine Stromsteuereinheit des Fahrzeugs so geregelt wird, dass er unter einem Nullpegel-Schwellenstrom (Iₗᵢₘ) liegt; und
- Messen der Spannung (U_{sys}) während des Pausenzeitintervalls durch Messen der Spannung (U_{sys}) zu einem Messzeitpunkt (tₘₑₐₛ), der innerhalb des Pausenzeitintervalls (ΔTₚₐᵤₛₑ) liegt, wobei der Messzeitpunkt (tₘₑₐₛ) gleich oder länger als eine Relaxationszeit (Tᵣₑₗ) der Spannung (U_{sys}) in Bezug auf den Beginn des Pausenzeitintervalls (ΔTₚₐᵤₛₑ) ist.

2. Verfahren nach Anspruch 1, wobei das Verfahren das Bestimmen umfasst, dass der Energiegehalt und die Leistung der Batterie des Elektrofahrzeugs nicht verfügbar sind, wenn die gemessene Spannung (U_{sys}) kleiner ist als die vorbestimmte Schwellenspannung (Uₗᵢₘ) und/oder der bestimmte Widerstand (R_{sys}) größer ist als der vorbestimmte Schwellenwiderstand (Rₗᵢₘ).

3. Verfahren nach einem der Ansprüche 1 bis 2, wobei der Nullschwellenstrom (Iₗᵢₘ) 100 mA oder weniger beträgt.

4. Verfahren nach einem der Ansprüche 1 bis 3, wobei das Bestimmen der Verfügbarkeit des Energiegehalts nur durchgeführt wird, wenn bestimmt wird, dass die Temperatur (T_{sys}) höher ist als eine Mindestschwellentemperatur.

5. Elektrofahrzeug mit einem Erfassungssystem (1) zur Bestimmung der ausreichenden Verfügbarkeit des Energiegehalts und der Leistung einer Batterie des Elektrofahrzeugs, umfassend:
eine erste Bestimmungseinheit (10) zum Bestimmen der ausreichenden Verfügbarkeit des Energiegehalts, umfassend:
- eine Messeinheit (12), die zum Messen der Spannung (U_{sys}) der Batterie konfiguriert ist;
- eine erste Komparatoreinheit (14), die so konfiguriert ist, dass sie die gemessene Spannung (U_{sys}) mit einer vorbestimmten Schwellenspannung (Uₗᵢₘ) vergleicht und bestimmt, ob die gemessene Spannung (U_{sys}) gleich oder größer als die vorbestimmte Schwellenspannung (Uₗᵢₘ) ist;
eine zweite Bestimmungseinheit (30) zum Bestimmen der ausreichenden Verfügbarkeit der Leistung, umfassend:
- eine Widerstandsbestimmungseinheit (32), die so konfiguriert ist, dass sie den Innenwiderstand (R_{sys}) der Batterie bestimmt;
- eine zweite Komparatoreinheit (34), die so konfiguriert ist, dass sie den bestimmten Innenwiderstand (R_{sys}) mit einem vorbestimmten Schwellenwiderstand (Rₗᵢₘ) vergleicht und bestimmt, ob der Innenwiderstand (R_{sys}) gleich oder kleiner als der vorbestimmte Schwellenwiderstand (Rₗᵢₘ) ist;
eine Logikeinheit (50), die so konfiguriert ist, dass sie bestimmt, ob der Energiegehalt und die Leistung der Batterie eines Elektrofahrzeugs ausreichend sind, wenn sowohl die gemessene Spannung (U_{sys}) gleich oder größer als die vorbestimmte Schwellenspannung (Uₗᵢₘ) ist als auch der Widerstand (R_{sys}) gleich oder kleiner als der vorbestimmte Schwellenwiderstand (Rₗᵢₘ) ist,
eine Steuereinheit, die so konfiguriert ist, dass sie die Spannung (U_{sys}) auf einem konstanten Pegel steuert und anschließend das Steuern der Spannung während eines Pausenzeitintervalls (ΔTₚₐᵤₛₑ) unterbricht, während der Batteriestrom (I_{sys}) durch eine Stromsteuereinheit des Fahrzeugs während des Pausenzeitintervalls (ΔTₚₐᵤₛₑ) so gesteuert wird, dass er unter einem Nullpegel-Schwellenstrom (Iₗᵢₘ) liegt, und
wobei die erste Bestimmungseinheit (10) so konfiguriert ist, dass sie die Spannung (U_{sys}) während des Pausenzeitintervalls misst, indem sie die Spannung (U_{sys}) zu einem Messzeitpunkt (tₘₑₐₛ) misst, der innerhalb des Pausenzeitintervalls (ΔTₚₐᵤₛₑ) liegt, wobei der Messzeitpunkt (tₘₑₐₛ) gleich oder länger ist als eine Relaxationszeit (Tᵣₑₗ) der Spannung (U_{sys}) in Bezug auf den Beginn des Pausenzeitintervalls (ΔTₚₐᵤₛₑ).

6. Elektrofahrzeug (1) nach Anspruch 5, wobei die Logikeinheit (50) so konfiguriert ist, dass sie bestimmt, dass der Energiegehalt und die Leistung einer Batterie eines Elektrofahrzeugs nicht verfügbar ist, wenn die gemessene Spannung (U_{sys}) kleiner als die vorbestimmte Schwellenspannung (Uₗᵢₘ) ist und/oder der bestimmte Widerstand (R_{sys}) größer als der vorbestimmte Schwellenwiderstand (Rₗᵢₘ) ist.

7. Elektrofahrzeug nach Anspruch 6, wobei der Nullschwellenstrom (Iₗᵢₘ) 100 mA oder weniger beträgt.

## Revendications

1. Procédé de détermination de la disponibilité suffisante du contenu en énergie et de l'alimentation d'une batterie d'un véhicule électrique :
dans lequel la détermination de la disponibilité suffisante du contenu en énergie comprend :
- la mesure de la tension (U_{sys}) de la batterie ;
- la comparaison de la tension mesurée (U_{sys}) avec une tension seuil prédéterminée (Uₗᵢₘ) et la détermination si la tension mesurée (U_{sys}) est égale ou supérieure à la tension seuil prédéterminée (Uₗᵢₘ) ;
dans lequel la détermination de la disponibilité suffisante de l'alimentation comprend :
- la détermination de la résistance interne (R_{sys}) de la batterie ;
- la comparaison de la résistance interne déterminée (R_{sys}) avec une résistance seuil prédéterminée (Rₗᵢₘ) et la détermination si la résistance interne déterminée (R_{sys}) est égale ou inférieure à la résistance seuil prédéterminée (Rₗᵢₘ) ;
la détermination que le contenu en énergie et l'alimentation de la batterie du véhicule électrique sont suffisants,
si à la fois la tension mesurée (U_{sys}) est égale ou supérieure à la tension seuil prédéterminée et la résistance déterminée (R_{sys}) est égale ou inférieure à la résistance seuil prédéterminée (Rₗᵢₘ) ;
**caractérisé en ce que**
la détermination de la disponibilité suffisante du contenu en énergie comprend en outre :
- la commande de la tension (U_{sys}), par le biais d'une unité de commande du véhicule, pour être à un niveau constant (CV) pendant une période de commande ;
- la mise en pause de la commande de la tension pendant un intervalle de temps de pause (ΔTₚₐᵤₛₑ) suivant la période de temps de commande tout en commandant le courant de batterie (I_{sys}), par le biais d'une unité de commande de courant du véhicule, pendant l'intervalle de temps de pause (ΔTₚₐᵤₛₑ) pour être inférieur à un courant seuil de niveau zéro (Iₗᵢₘ) ; et
- la mesure de la tension (U_{sys}) pendant l'intervalle de temps de pause par la mesure de la tension (U_{sys}) à un temps de mesure (tₘₑₐₛ) qui est à l'intérieur de l'intervalle de temps de pause (ΔTₚₐᵤₛₑ) , dans lequel le temps de mesure (tₘₑₐₛ) est égal ou supérieur à un temps de relaxation (Tᵣₑₗ) de la tension (U_{sys}) par rapport au démarrage de l'intervalle de temps de pause (ΔTₚₐᵤₛₑ) .

2. Procédé selon la revendication 1, dans lequel le procédé comprend la détermination que le contenu en énergie et l'alimentation de la batterie du véhicule électrique ne sont pas disponibles, si la tension mesurée (U_{sys}) est inférieure à la tension seuil prédéterminée (Uₗᵢₘ) et/ou la résistance déterminée (R_{sys}) est supérieure à la résistance seuil prédéterminée (Rₗᵢₘ).

3. Procédé selon l'une des revendications 1 à 2, dans lequel le courant seuil de niveau zéro (Iₗᵢₘ) est de 100 mA ou moins.

4. Procédé selon les revendications 1 à 3, dans lequel la détermination de la disponibilité du contenu en énergie est uniquement réalisée s'il est déterminé que la température (T_{sys}) est supérieure à une température seuil minimale.

5. Véhicule électrique comportant un système de détection (1) permettant de déterminer la disponibilité suffisante du contenu en énergie et de l'alimentation d'une batterie du véhicule électrique, comprenant :
une première unité de détermination (10) pour déterminer la disponibilité suffisante du contenu en énergie, comprenant :
- une unité de mesure (12) configurée pour mesurer la tension (U_{sys}) de la batterie ;
- une première unité de comparateur (14) configurée pour comparer la tension mesurée (U_{sys}) avec une tension seuil prédéterminée (Uₗᵢₘ) et déterminant si la tension mesurée (U_{sys}) est égale ou supérieure à la tension seuil prédéterminée (Uₗᵢₘ) ;
une deuxième unité de détermination (30) pour déterminer la disponibilité suffisante de l'alimentation, comprenant :
- une unité de détermination de résistance (32) configurée pour déterminer la résistance interne (R_{sys}) de la batterie ;
- une deuxième unité de comparateur (34) configurée pour comparer la résistance interne déterminée (R_{sys}) avec une résistance seuil prédéterminée (Rₗᵢₘ) et déterminant si la résistance interne (R_{sys}) est égale ou inférieure à la résistance seuil prédéterminée (Rₗᵢₘ) ;
une unité logique (50) configurée pour déterminer si le contenu en énergie et l'alimentation de la batterie d'un véhicule électrique sont suffisants,
si à la fois la tension mesurée (U_{sys}) est égale ou supérieure à la tension seuil prédéterminée (Uₗᵢₘ) et la résistance (R_{sys}) est égale ou inférieure à la résistance seuil prédéterminée (Rₗᵢₘ),
une unité de commande configurée pour commander la tension (U_{sys}) à un niveau constant et ensuite mettre en pause la commande de la tension pendant un intervalle de temps de pause (ΔTₚₐᵤₛₑ) alors que le courant de batterie (I_{sys}) est commandé par le biais d'une unité de commande de courant du véhicule pendant l'intervalle de temps de pause (ΔTₚₐᵤₛₑ) pour être inférieur à un courant seuil de niveau zéro (Iₗᵢₘ), et
dans lequel la première unité de détermination (10) est configurée pour mesurer la tension (U_{sys}) pendant l'intervalle de temps de pause par la mesure de la tension (U_{sys}) à un temps de mesure (Tₘₑₐₛ) qui est à l'intérieur de l'intervalle de temps de mesure (ΔTₚₐᵤₛₑ), dans lequel le temps de mesure (tₘₑₐₛ) est égal ou supérieur à un temps de relaxation (Tᵣₑₗ) de la tension (U_{sys}) par rapport au début de l'intervalle de temps de pause (ΔTₚₐᵤₛₑ) .

6. Véhicule électrique (1) selon la revendication 5, dans lequel l'unité logique (50) est configurée pour déterminer que le contenu en énergie et l'alimentation d'une batterie d'un véhicule électrique ne sont pas disponibles, si la tension mesurée (U_{sys}) est inférieure à la tension seuil prédéterminée (Uₗᵢₘ) et/ou la résistance déterminée (R_{sys}) est supérieure à la résistance seuil prédéterminée (Rₗᵢₘ).

7. Véhicule électrique selon la revendication 6, dans lequel le courant seuil de niveau zéro (Iₗᵢₘ) est de 100 mA ou moins.
